# EUROPEAN PATENT APPLICATION

(11) **EP 4 459 852 A1**
(43) Date of publication of application: **06.11.2024**
(21) Application number: 21969226.6
(22) Date of filing: 28.12.2021
(51) Int. Cl.: H02K 11/30

(54) **MOTOR UNIT**

(71) Applicant: JTEKT Corporation, Kariya-shi, Aichi 448-8652 (JP)
(72) Inventor: HAYASHI Yuki, Kariya-shi, Aichi 448-8652 (JP); YOKOYAMA Tokio, Kariya-shi, Aichi 448-8652 (JP); SATO Yuto, Kariya-shi, Aichi 448-8652 (JP); MATSUDA Masahiro, Kariya-shi, Aichi 448-8652 (JP)
(74) Representative: Winter, Brandl - Partnerschaft mbB
(86) International application number: PCT/JP2021/048793
(87) International publication number: WO 2023/127098

(57) **Abstract**

A control device (3) of a motor unit (1) includes an external connector (42), a first board (43), a second board (44), and a circuit component (46). The external connector (42) has a base portion (61), and a positioning pin (65) that projects from the base portion (61) toward a motor (2). The first board (43) has a first through hole (71), and the second board (44) has a second through hole (72) provided at a position corresponding to the first through hole (71). The common positioning pin (65) is inserted into the first through hole (71) and the second through hole (72).

## Description

### TECHNICAL FIELD

The present disclosure relates to a motor unit.

### BACKGROUND ART

Conventionally, there is a motor unit in which a control device, for controlling operations of a motor, is integrated into the motor. Such a control device for a motor unit includes, for example, a power board, a control board, and an external connector to which external wiring is connected, as described in Patent Document 1. In this control device, the power board is directly fixed to a heat sink of the motor. On the other hand, the control board is fixed to the external connector, and the external connector is fixed to the heat sink. That is to say, the control board is fixed to the heat sink via the external connector.

### Related Art Documents

### Patent Documents

Patent Document 1: Japanese Unexamined Patent Application Publication No. 2021-65018 (JP 2021-65018 A)

### SUMMARY OF THE INVENTION

### Problem to be Solved by the Invention

In the control device according to the above Patent Document 1, relative positions of the power board and the heat sink vary within a range of manufacturing and assembly tolerances, for example. In the same way, relative positions of the control board and the external connector, and relative positions of the external connector and the heat sink, also vary within their respective tolerances. Accordingly, when these tolerances converge, there is a concern that variance in relative positions of the power board and the control board will increase.

### Means for Solving the Problem

In one aspect of the present disclosure, a motor unit is provided. The motor unit includes a motor, and a control device configured to control the motor. The control device includes an external connector that is disposed spaced apart from the motor along an axis of the motor, a first board that is disposed between the motor and the external connector, in an orientation intersecting the axis of the motor, a second board that is disposed between the first board and the external connector, in array with the first board, and a circuit component that is mounted on the first board and the second board. The external connector has a base portion, and a positioning pin protruding from the base portion toward the motor. The first board has a first through hole, and the second board has a second through hole provided at a position corresponding to the first through hole. A common positioning pin is inserted into the first through hole and the second through hole.

### BRIEF DESCRIPTION OF THE DRAWINGS

[FIG. 1] FIG. 1 is a perspective view of a motor unit according to an embodiment.
[FIG. 2] FIG. 2 is a partial cross-sectional view of a vicinity of a control device in the motor unit in FIG. 1.
[FIG. 3] FIG. 3 is a disassembled perspective view of the motor unit in FIG. 1.
[FIG. 4] FIG. 4 is an enlarged sectional view of a vicinity of a positioning pin of an external connector in a motor unit according to a modification.

### MODES FOR CARRYING OUT THE INVENTION

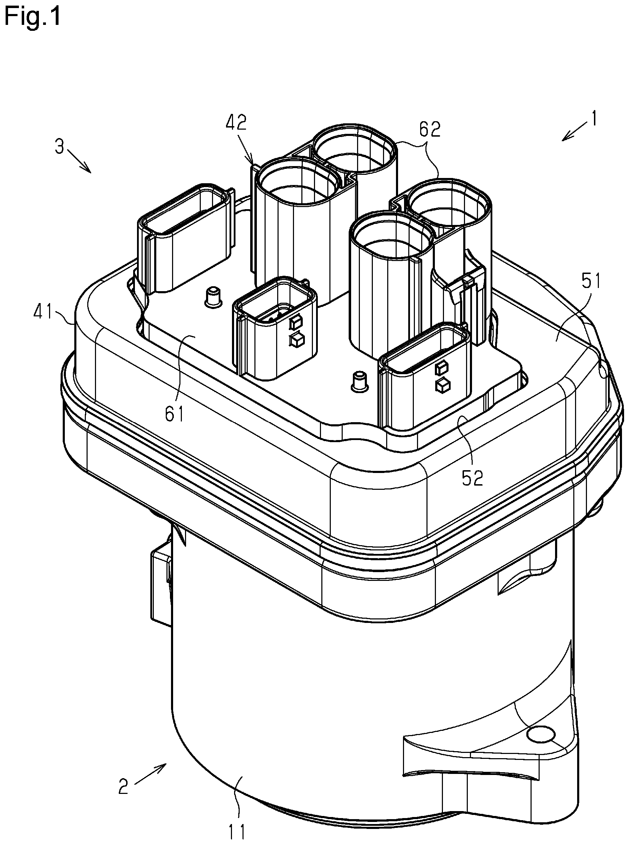

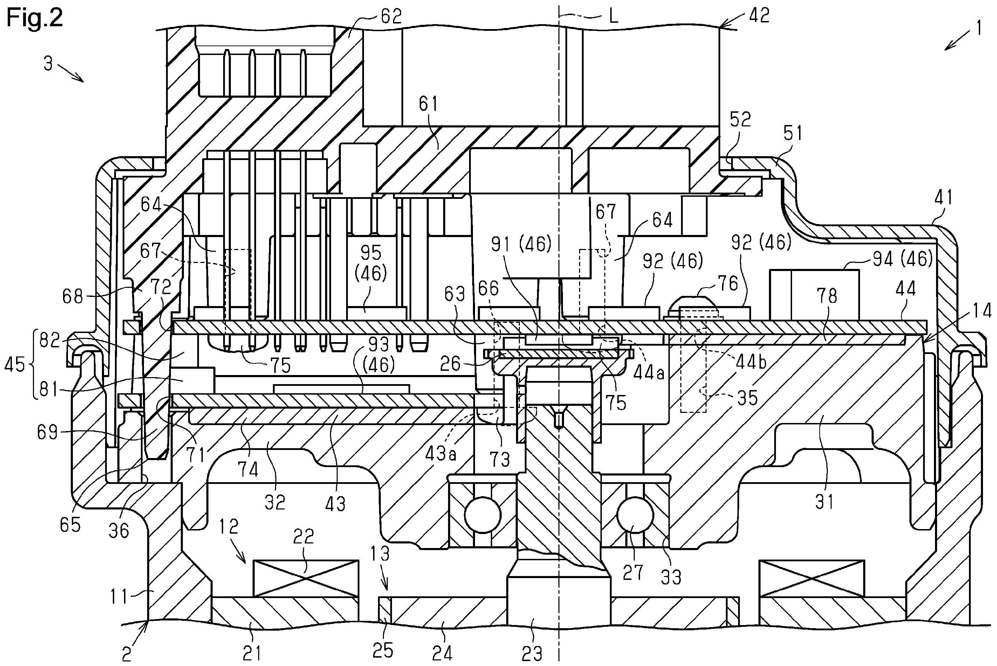

An embodiment of a motor unit will be described below with reference to the drawings. As illustrated in FIG. 1 and FIG. 2, a motor unit 1 includes a motor 2 and a control device 3 that controls operations of the motor 2. The control device 3 is fixed to one end portion of the motor 2 in an axial direction thereof. In the following description, the side of the motor 2 on which the control device 3 is disposed will be referred to as a first side, and the opposite side therefrom will be referred to as a second side.

### (Motor 2)

The motor 2 is, for example, a three-phase brushless motor. The motor 2 includes a housing 11 that is tubular, a stator 12 fixed within the housing 11, a rotor 13 rotatably disposed on an inner peripheral side of the stator 12, and a heat sink 14.

Note that it is sufficient for the term "tubular" as used in the present specification to be an arrangement that can be deemed to be a tubular shape overall, and tubular shapes formed by combining a plurality of component, and shapes formed by partially notching out into a letter-C shape part or the like, are included therein. The term "tubular" shape encompasses, circles, ellipses, and polygons with sharp or rounded corners as viewed in the axial direction, but is not limited thereto.

As illustrated in FIG. 2, the stator 12 includes a stator core 21 and a plurality of coil groups 22. The stator core 21 is fixed to an inner periphery of the housing 11. Each coil group 22 has motor coils of three phases of U, V, and W, which are wound around teeth of the stator core 21. Each coil group 22 is configured to be independently supplied with driving electric power from the control device 3. That is to say, the motor 2 has a redundant configuration regarding the motor coils.

The rotor 13 includes a rotating shaft 23, a rotor core 24, a rotor magnet 25, and a sensor magnet 26. The rotating shaft 23 is rotatably supported by a bearing 27 provided on the heat sink 14. That is to say, the heat sink 14 is used as a bearing holder. Note that the heat sink 14 may be referred to as a bearing holder. The rotor core 24 is fixed to an outer periphery of the rotating shaft 23. The rotor magnet 25 is fixed to an outer periphery of the rotor core 24, for example. The sensor magnet 26 is fixed to a first side end portion of the rotating shaft 23.

In the motor 2 configured in this way, a rotating magnetic field is generated in the stator 12 by supplying driving electric power from the control device 3 to each coil group 22, and the rotor 13 rotates in accordance with this rotating magnetic field.

### (Heat Sink 14)

Next, a configuration of the heat sink 14 will be described in detail.

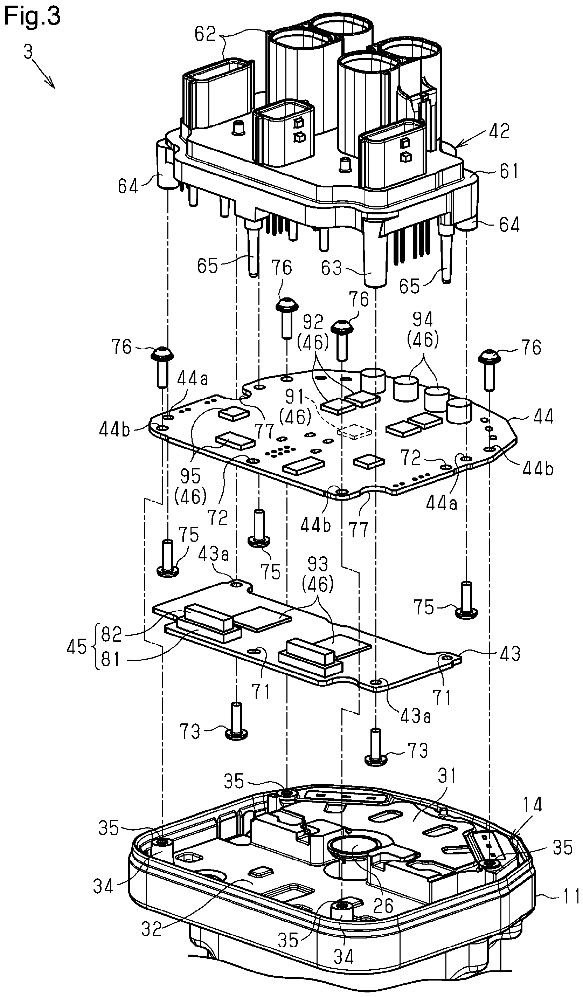

As illustrated in FIG. 2 and FIG. 3, the heat sink 14 is made of a metal material such as, for example, an aluminum alloy. The heat sink 14 has a plate-like shape that covers an opening on the first side of the housing 11. The heat sink 14 has, for example, a substantially square shape as viewed in the axial direction of the motor 2, as illustrated. The heat sink 14 is disposed within a first side end portion of the housing 11. The heat sink 14 is rigidly fixed to the housing 11 by, for example, bolts that are omitted from illustration.

The heat sink 14 has a raised portion 31 and a sunken portion 32 that is sunken to the second side as compared to the raised portion 31. That is to say, the sunken portion 32 is sunken away from an external connector 42, which will be described later. In other words, the raised portion 31 is raised toward the first side as compared to the sunken portion 32. Accordingly, the heat sink 14 has a stepped-plate-like shape. The thickness of the raised portion 31 along the axis L of the motor 2 is greater than the thickness of the sunken portion 32 along the axis L. In the present embodiment, the heat sink 14 is divided into two regions by a straight line orthogonal to the axis L of the motor 2, one of which is the sunken portion 32 and the other is the raised portion 31. Thus, each of the sunken portion 32 and the raised portion 31 has a substantially rectangular shape as viewed in the axial direction of the motor 2. In another embodiment, for example, the sunken portion 32 may be in a letter-L shape as viewed in the axial direction of the motor 2, and the shapes of the sunken portion 32 and the raised portion 31 can be changed as appropriate.

The heat sink 14 has a holding hole 33. The holding hole 33 passes through the heat sink 14 along the axis L of the motor 2. The bearing 27 is provided on an inner periphery of the holding hole 33.

As illustrated in FIG. 3, the heat sink 14 has one or more supporting protrusions 34 that protrude from the sunken portion 32 toward the first side. The heat sink 14 has, for example, two supporting protrusions 34. The supporting protrusions 34 are post-like, for example. The height of the supporting protrusions 34 from the sunken portion 32 is substantially equal to the height of the raised portion 31 from the sunken portion 32. The supporting protrusions 34 are provided at corner portions of the sunken portion 32, for example.

The heat sink 14 has one or more screw holes 35 opening on the first side. The heat sink 14 has, for example, four screw holes 35. The screw holes 35 are provided in the supporting protrusions 34 and in the raised portion 31.

As illustrated in FIG. 2, the heat sink 14 has one or more positioning holes 36 opening on the first side. The heat sink 14 has, for example, two positioning holes 36. The positioning holes 36 are provided, for example, at an edge portion of the sunken portion 32. Inner peripheral faces of the positioning holes 36 are smooth cylindrical shapes.

### (Control Device 3)

The control device 3 includes a cover 41, an external connector 42, a first board 43, a second board 44, an inter-board connector pair 45, and various circuit components 46. Wiring extending from the outside of the motor unit 1 is connected to the external connector 42. The external connector 42 supports the first board 43 and the second board 44. The inter-board connector pair 45 electrically connects the first board 43 and the second board 44 to each other. Various types of circuit components 46 are mounted on the first board 43 and the second board 44. A drive circuit that supplies driving electric power to the motor 2 and a control circuit that controls operations of the drive circuit are configured by mounting the various types of circuit components 46 at predetermined positions on the first board 43 and the second board 44. Note that illustration of the cover 41 is omitted in FIG. 3, for sake of convenience in description.

The control device 3 according to the present embodiment has the same number of drive circuits and control circuits as the number of coil groups 22, in accordance with the stator 12 having multiple coil groups 22. In other words, the control device 3 has a configuration in which a power supply system that supplies power to the coil groups 22 and a control system are redundant.

In the control device 3 configured in this way, the drive circuit operates based on control signals output from the control circuit, and supplies driving electric power to the motor 2. Each component of the control device 3 will be described in detail below.

### (Cover 41)

As illustrated in FIG. 1 and FIG. 2, the cover 41 has a tubular shape. The cover 41 has an end wall 51 provided at a first side end portion thereof. The end wall 51 has an opening portion 52 passing therethrough in the axial direction. The cover 41 is fixed to the housing 11 by fitting a second side end portion of the cover 41 to the first side end portion of the housing 11. Thus, the cover 41 covers the opening on the first side of the housing 11 so that the first board 43, the second board 44, and so forth, are not exposed. Note that the opening portion 52 is closed by the external connector 42.

### (External Connector 42)

The external connector 42 is made of, for example, a resin material. As illustrated in FIG. 2 and FIG. 3, the external connector 42 has a base portion 61, one or more socket portions 62, one or more first board supports 63, and one or more second board supports 64, and one or more positioning pins 65.

The base portion 61 has a flat plate-like shape that covers the entire opening portion 52 of the cover 41. The external connector 42 is provided with, for example, five socket portions 62. The socket portions 62 project from the base portion 61 through the opening portion 52 to the first side, i.e., to the outside of the cover 41. The socket portions 62 are configured with corresponding external wiring inserted thereinto. Connection terminals provided within the socket portions 62 are connected to predetermined positions on the second board 44.

The external connector 42 is provided with, for example, two first board supports 63. The first board supports 63 protrude from the base portion 61 toward the second side, i.e., toward the motor 2. The first board supports 63 are post-like, for example. The first board supports 63 have first screw holes 66 opening at distal ends thereof. The first board supports 63 are provided, for example, at an edge portion of the base portion 61.

The external connector 42 is provided with, for example, three second board supports 64. The second board supports 64 protrude from the base portion 61 toward the second side, i.e., toward the motor 2. The second board supports 64 are post-like, for example. The second board supports 64 have second screw holes 67 opening at distal ends thereof. The second board supports 64 are provided, for example, at the edge portion of the base portion 61. The amount of protrusion of the second board supports 64 toward the second side is smaller than the amount of protrusion of the first board supports 63 toward the second side. In other words, the first board supports 63 protrude more toward the motor 2 than the second board supports 64 do.

The external connector 42 is provided with, for example, two positioning pins 65. The positioning pins 65 protrude from the base portion 61 toward the second side, i.e., toward the motor 2. The positioning pins 65 are post-like, for example. The positioning pins 65 protrude more toward the motor 2 than the first board supports 63 and the second board supports 64. The positioning pins 65 each have a large diameter portion 68 and a small diameter portion 69 having a smaller outside diameter than the large diameter portion 68. The small diameter portion 69 is provided continuously on the second side of the large diameter portion 68. An outer peripheral face of a distal end portion of the small diameter portion 69, i.e., the distal end portion of the positioning pin 65, has a smooth cylindrical shape.

### (First Board 43 and Second Board 44)

Both the first board 43 and the second board 44 have a flat plate-like shape. The first board 43 has substantially the same size as the sunken portion 32 of the heat sink 14 as viewed in the axial direction of the motor 2. The second board 44 has substantially the same size as the entire heat sink 14 as viewed in the axial direction of the motor 2. The first board 43 is disposed between the heat sink 14 of the motor 2 and the external connector 42, in an orientation orthogonal to the axis L of the motor 2. The second board 44 is disposed between the first board 43 and the external connector 42, in an orientation orthogonal to the axis L of the motor 2. That is to say, the second board 44 is disposed parallel to the first board 43. Accordingly, the first board 43, the second board 44, and the external connector 42 are arrayed in the order of the first board 43, the second board 44, and the external connector 42, from the heat sink 14, on the first side.

The first board 43 has the same number of first through holes 71 as the positioning holes 36. The first through holes 71 are provided at positions facing the positioning holes 36 in the axial direction of the motor 2. The second board 44 has the same number of second through holes 72 as the positioning holes 36. The second through holes 72 are provided at positions facing the positioning holes 36 and the first through holes 71 in the axial direction of the motor 2. That is to say, the positioning holes 36, the first through holes 71, and the second through holes 72 are disposed on straight lines parallel to the axis L of the motor 2.

In the present specification, "facing" refers to faces or members that are positioned in front of each other, and includes not only when positioned completely in front of each other, but also when positioned partially in front of each other. Also, "facing" in the present specification may include both when a member that is different from the two portions is interposed between the two portions, and when nothing is interposed between the two portions. Also, "facing" in the present specification may include both when two portions that face each other are in contact with each other, and when there is a space therebetween.

Common positioning pins 65 are inserted into the second through holes 72, the first through holes 71, and the positioning holes 36. That is to say, the first board 43, the second board 44, and the heat sink 14 are positioned relative to the external connector 42 by the common positioning pins 65.

Specifically, the positioning pins 65 are inserted into the second through holes 72, and also the portions of the positioning pins 65 that protrude from the second through holes 72 toward the second side are inserted into the first through holes 71. The portions of the positioning pins 65 that protrude from the first through holes 71 toward the second side are inserted into the positioning holes 36. Note that the large diameter portions 68 of the positioning pins 65 face the second board 44 with a space as to the second board 44 along the axis L. That is to say, the large diameter portions 68 do not come into contact with the second board 44 from the first side.

The first board 43 is fixed to the first board supports 63. Specifically, the first board 43 has first insertion holes 43a at positions facing the first screw holes 66 of the first board supports 63. The first board 43 is fixed to the distal ends of the first board supports 63 by screwing first bolts 73 into the first screw holes 66 through the first insertion holes 43a. The first board 43 is disposed on the first side of the sunken portion 32.

A heat dissipation material 74 is interposed between the first board 43 and the sunken portion 32. The heat dissipation material 74 is, for example, thermal grease. Thus, heat generated by the circuit components 46 mounted on the first board 43 is dissipated to the heat sink 14. Hereinafter, the face of the first board 43 facing the sunken portion 32 will be referred to as a rear face, and the face on the opposite side therefrom will be referred to as a front face.

The second board 44 is fixed to the second board supports 64. Also, the second board 44 is fixed to the heat sink 14. Specifically, second insertion holes 44a are provided at positions facing the second screw holes 67 of the second board supports 64. Also, the second board 44 has second insertion holes 44b at positions facing the screw holes 35 of the heat sink 14 in the axial direction. The second board 44 is fixed to the distal ends of the second board supports 64 by screwing second bolts 75 into the second screw holes 67 through the second insertion holes 44a. Also, the second board 44 is rigidly fixed to the first side of the heat sink 14 by screwing fixing screws 76 into the screw holes 35 through the second insertion holes 44a. Thus, the second board 44 covers the first board 43 from the first side. Note that the second board 44 has notches 77 at positions corresponding to the first board supports 63, to avoid interference with the first board supports 63.

A heat dissipation material 78 is interposed between the second board 44 and the raised portion 31. The heat dissipation material 78 is, for example, thermal grease. Thus, heat generated by the circuit components 46 mounted on the second board 44 is dissipated to the heat sink 14. Hereinafter, the face of the second board 44 facing the raised portion 31 will be referred to as a rear face, and the face on the opposite side therefrom will be referred to as a front face.

As described above, the external connector 42 is only indirectly fixed to the heat sink 14 via the second board 44, and not directly fixed thereto. Also, the first board 43 is only indirectly fixed to the heat sink 14 via the external connector 42 and the second board 44, and not directly fixed thereto. Further, no heat sink is provided in the space between the first board 43 and the second board 44. This space is a space for accommodating circuit components 46 mounted on the first board 43 and the second board 44.

### (Inter-board Connector Pair 45)

The inter-board connector pair 45 includes a first connector 81 mounted on the first board 43 and a second connector 82 mounted on the second board 44. By fitting the first connector 81 to the second connector 82, the first board 43 is electrically connected to the second board 44. Thus, the circuit components 46 mounted on the first board 43 exchange signals with the circuit components 46 mounted on the second board 44, via the inter-board connector pair 45.

The second connector 82 is configured to be displaceable relative to the first connector 81 in an orthogonal direction that is orthogonal to the axial direction of the motor 2. That is to say, the inter-board connector pair 45 is a floating-type connector pair that allows displacement in the orthogonal direction between the first connector 81 and the second connector 82. The inter-board connector pair 45 according to the present embodiment employs an arrangement that has a relatively small floating amount, which is an allowable displacement amount in the orthogonal direction.

### (Circuit Components 46)

The circuit components 46 include a magnetic sensor 91 that detects magnetic flux of the sensor magnet 26 fixed to the rotating shaft 23 of the rotor 13. The magnetic sensor 91 is mounted on the rear face of the second board 44 so as to face the sensor magnet 26 in the axial direction.

Also, the circuit components 46 include drive circuit components 92 that makes up a drive circuit, and control circuit components 93 that makes up a control circuit. The drive circuit components 92 includes a plurality of switching devices such as FETs, IGBTs, and so forth, for example. The drive circuit components 92 are mounted in a region of the second board 44 that faces the raised portion 31. The drive circuit components 92 are mounted, for example, on the front face of the second board 44, but may be mounted on the rear face. The control circuit components 93 include, for example, a microcomputer. The control circuit components 93 control the operations of the drive circuit by outputting control signals that switch on/off states of the switching devices. The control circuit components 93 are mounted on the first board 43. The control circuit components 93 are mounted, for example, on the front face of the first board 43, but may be mounted on the rear face.

Further, the circuit components 46 includes large-sized and heavy components 94 that are larger and heavier than other circuit components. The large-sized and heavy components 94 include a capacitor and a coil for smoothing the driving electric power supplied from a power source, for example. The large-sized and heavy components 94 are mounted in a region of the second board 44 facing the raised portion 31. The large-sized and heavy components 94 are mounted, for example, on the front face of the second board 44, but may be mounted on the rear face thereof.

Further, the circuit components 46 includes lightweight and low-heat-generating components 95 which are small and generates less heat than other circuit components. The lightweight and low-heat-generating components 95 include, for example, a pre-driver for boosting voltage of control signals to a voltage suitable for operation of the switching devices, and a power source IC for generating a driving voltage for driving the microcomputer. Also, the lightweight and low-heat-generating components 95 may include an IC for a communication network. The lightweight and low-heat-generating components 95 are primarily mounted in a region of the second board 44 facing the sunken portion 32. The lightweight and low-heat-generating components 95 are mounted, for example, on the front face of the second board 44, but may be mounted on the rear face thereof. Also, the lightweight and low-heat-generating components 95 are also mounted on the first board 43 and the second board 44, in regions facing the raised portion 31.

Next, the effects and advantages of the present embodiment will be described.
(1) The control device 3 includes the external connector 42 that is disposed spaced apart from the motor 2 along the axis L of the motor 2, and the first board 43 and the second board 44 disposed between the motor 2 and the external connector 42 in orthogonal orientations as to the axis L of the motor 2. The external connector 42 has the base portion 61 and the positioning pins 65 that project from the base portion 61 toward the motor 2. The first board 43 has first through holes 71, and the second board 44 has second through holes 72 provided at positions corresponding to the first through holes 71. The common positioning pins 65 are inserted into the first through holes 71 and the second through holes 72.

According to the above configuration, the second board 44 is positioned with respect to the external connector 42 by the positioning pins 65, and the first board 43 is positioned with respect to the external connector 42 by the positioning pins 65 that position the second board 44. Accordingly, variance in the relative positions of the first board 43 and the second board 44 can be suppressed from becoming great, as compared to, for example, when the first board 43 is positioned with respect to the external connector 42 via another member.

(2) The control device 3 further includes the inter-board connector pair 45 including the first connector 81 that is mounted on the first board 43 and the second connector 82 that is mounted on the second board 44 and is connected to the first connector 81. Accordingly, the first board 43 and the second board 44 can be easily electrically connected to each other by the inter-board connector pair 45.

Now, when the variance in the relative positions of the first board 43 and the second board 44 is great, using an inter-board connector pair 45 with a large floating amount becomes necessary. In this regard, according to the present embodiment, inserting the common positioning pins 65 into the first through holes 71 and the second through holes 72 enables variance in the relative positions between the first board 43 and the second board 44 to be suppressed. Accordingly, an inter-board connector pair 45 that has a relatively small floating amount can be employed. Accordingly, reduction in size of the first board 43 and the second board 44, and consequently reduction in size the motor unit 1, can be realized. Thus, applying the configuration, in which the common positioning pins 65 are inserted into the first through holes 71 and the second through holes 72, to the motor unit 1 having the inter-board connector pair 45, is greatly advantageous.

(3) The motor 2 includes the heat sink 14 made of a metal material. The heat sink 14 has the raised portion 31 and the sunken portion 32 that is sunken further away from the external connector 42 than the raised portion 31. The second board 44 is disposed on the first side of the raised portion 31 so as to cover a part of the sunken portion 32. The first board 43 is disposed between the sunken portion 32 and the second board 44. The heat dissipation materials 74 and 78 are interposed between the first board 43 and the sunken portion 32, and between the second board 44 and the raised portion 31, respectively.

According to the above configuration, the heat sink 14 has a stepped shape, and accordingly each of the two boards 43 and 44 disposed side by side can be brought into contact with the heat sink 14. Accordingly, heat generated in the first board 43 is dissipated to the heat sink 14 via the sunken portion 32, and heat generated in the second board 44 is dissipated to the bearing holder via the raised portion 31. Thus, heat generated at the first board 43 and the second board 44 can be efficiently dissipated, while suppressing the motor unit 1 from increasing in size in the axial direction, as compared to when a heat sink is separately provided between the first board 43 and the second board 44, for example.

(4) The external connector 42 further has the first board supports 63 that protrude from the base portion 61 toward the motor 2. The first board 43 is fixed to the distal ends of the first board supports 63. According to the above configuration, the first board 43 is fixed to the external connector 42 which is the positioned object, and accordingly the relative positions between the first board 43 and the external connector 42 can be maintained suitably.

(5) The external connector 42 further includes the second board supports 64 that protrude from the base portion 61 toward the motor 2. The second board 44 is fixed to the distal ends of the second board supports 64. According to the above configuration, the second board 44 is fixed to the external connector 42 which is the positioned object, and accordingly the relative positions between the second board 44 and the external connector 42 can be maintained suitably.

(6) The heat sink 14 has the positioning holes 36 provided at positions corresponding to the first through holes 71 and the second through holes 72. The common positioning pins 65 are inserted into the first through holes 71, the second through holes 72, and the positioning holes 36. According to the above configuration, the heat sink 14 is positioned with respect to the external connector 42 by the positioning pin 65 that positions the first board 43 and the second board 44. Thus, increase in variance in the relative positions of the first board 43, the second board 44, and the heat sink 14 can be suppressed, as compared to, for example, when the heat sink 14 is positioned with respect to the external connector 42 via another member.

(7) The motor 2 further includes the rotating shaft 23 and the sensor magnet 26 fixed to the first side end portion of the rotating shaft 23. The heat sink 14 is configured to hold the bearing 27 that rotatably supports the rotating shaft 23. The circuit components 46 include the magnetic sensor 91 that is mounted on the second board 44 so as to face the sensor magnet 26.

According to the above configuration, the rotating shaft 23 is rotatably supported by the heat sink 14 in which variance in relative position with each of the boards 43 and 44 is suppressed from increasing. Thus, increase in variance in the relative positions of the sensor magnet 26 fixed to the rotating shaft 23 and the magnetic sensor 91 can be suppressed. Accordingly, rotational angle of the motor 2 can be detected with high precision.

(8) The circuit components 46 include the drive circuit components 92 that make up a drive circuit for supplying driving electric power to the motor 2. The drive circuit components 92 are mounted in a region of the second board 44 that faces the raised portion 31. Accordingly, the heat generated by the drive circuit components 92 can be efficiently dissipated to the raised portion 31. Now, the amount of heat generated by the drive circuit components 92 tends to be greater than that of other circuit components. In this respect, the thickness of the raised portion 31 along the axis L of the motor 2 can be made to be greater than the sunken portion 32. Accordingly, mounting the drive circuit components 92 in the region of the second board 44 facing the raised portion 31 enables overheating of the drive circuit components 92 to be suitably suppressed.

(9) The circuit components 46 includes the control circuit components 93 that make up a control circuit for controlling the operations of the drive circuit. The control circuit components 93 are mounted on the first board 43. Accordingly, the heat generated by the control circuit components 93 can be efficiently dissipated to the sunken portion 32. Here, the amount of heat generated by the control circuit components 93 tends to be great among the circuit components making up the control circuit. Accordingly, mounting the control circuit components 93 on the first board 43 enables overheating of the control circuit components 93 to be suitably suppressed.

(10) The second board 44 is rigidly fixed to the heat sink 14. The circuit components 46 include the large-sized and heavy components 94 including a capacitor and a coil. The large-sized and heavy components 94 are mounted on the second board 44. According to the above configuration, the second board 44 is rigidly fixed to the heat sink 14 that is highly rigid, even when the large-sized and heavy components 94 are mounted on the second board 44, the second board 44 can be suppressed from deflecting significantly when vibration is applied from the outside.

(11) The circuit components 46 include the lightweight and low-heat-generating components 95 including the pre-driver and the power source IC. The lightweight and low-heat-generating components 95 are primarily mounted in a region of the second board 44 facing the sunken portion 32. Accordingly, the heat generated by the lightweight and low-heat-generating components 95 is dissipated to the raised portion 31, from the region of the second board 44 facing the sunken portion 32 via the region facing the raised portion 31. In this way, although the heat generated by the lightweight and low-heat-generating components 95 is difficult to be efficiently dissipated, the amount of heat generated by the lightweight and low-heat-generating components 95 is small, and accordingly the lightweight and low-heat-generating components 95 can be suppressed from overheating. Thus, the circuit components 46 can be mounted over the entire second board 44 while suppressing overheating of all the circuit components 46.

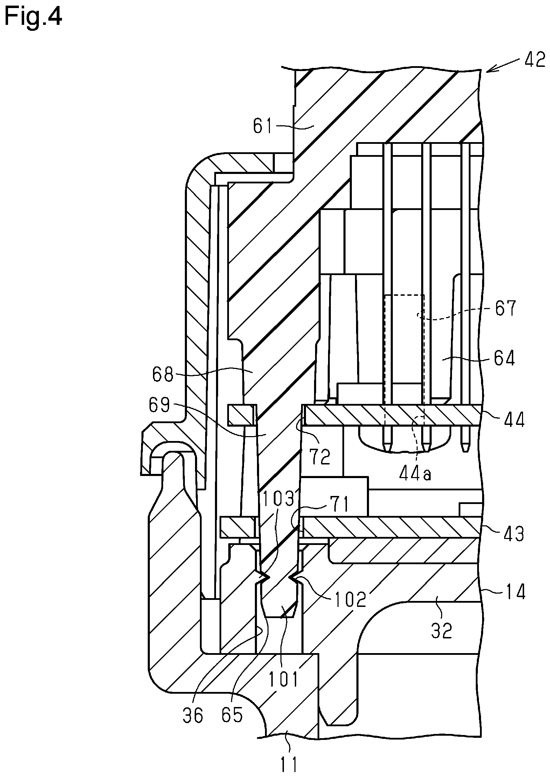

The present embodiment can be carried out modified as follows. The present embodiment and the following modifications can be combined with each other and carried out, insofar as no technical contradiction arises.
- The lightweight and low-heat-generating components 95 may be mounted primarily in the region of the first board 43 or the second board 44 that faces the raised portion 31.
   - The large-sized and heavy components 94 may be mounted in the region of the first board 43 or the second board 44 that faces the sunken portion 32.
- The control circuit components 93 may be mounted on the second board 44.
   - The drive circuit components 92 may be mounted in a region of the first board 43 or the second board 44 that faces the sunken portion 32.
- Although the magnetic sensor 91 is mounted on the second board 44, this is not restrictive, and may be mounted on the first board 43. In this case, the first board 43 will extend to a position facing the rotating shaft 23. Also, the circuit components 46 do not have to include the magnetic sensor 91. That is to say, the motor unit 1 does not have to include the sensor magnet 26 and the magnetic sensor 91.
   - Although both the inner peripheral faces of the positioning holes 36 and the outer peripheral faces of the distal end portions of the positioning pins 65 have cylindrical shapes, this is not restrictive. For example, as illustrated in FIG. 4, an outer peripheral face of a distal end portion 101 of the positioning pin 65 that protrudes from the first through hole 71 to the second side may have a retaining recess 102, and the inner peripheral face of the positioning hole 36 may have a retaining protrusion 103 that retains the retaining recess 102. The retaining recess 102 may be, for example, a groove extending in a circumferential direction of the distal end portion 101, or a hole recessed in a radial direction of the distal end portion 101. The retaining protrusion 103 may be, for example, a flange-like projection extending in the circumferential direction of the positioning hole 36 or a projection projecting in the radial direction. According to this configuration, the external connector 42 is directly fixed to the heat sink 14, the external connector 42 can be firmly fixed to the motor 2.
   - Although the large diameter portion 68 of the positioning pin 65 is not in contact with the surface of the second board 44, this is not restrictive. For example, as illustrated in FIG. 4, a distal end of the large diameter portion 68 may come into contact with the surface of the second board 44. In this case, the large diameter portion 68 corresponds to a contacting portion, and the surface of the second board 44 corresponds to a facing face that faces the external connector 42. According to this configuration, the second board 44 is supported by the large diameter portion 68, and accordingly the second board 44 can be fixed more firmly. Note that the control device 3 in the example illustrated in FIG. 4 is provided with both of the feature of the positioning pin 65 having the retaining recess 102 and also the positioning hole 36 having the retaining protrusion 103, and the feature of the large diameter portion 68 coming into contact with the surface of the second board 44, but just one of these features may be provided.
   - A core material such as a metal rod or the like, for example, may be provided inside of the positioning pins 65.
- Although the first board 43 and the second board 44 are disposed between the motor 2 and the external connector 42 in an orientation orthogonal to the axis L of the motor 2, this is not restrictive, and the first board 43 and the second board 44 may be disposed in an orientation intersecting the axis L. Also, the second board 44 does not have to be parallel to the first board 43.
   - Although the first board 43 is fixed only to the first board supports 63, this is not restrictive, and the first board 43 may be fixed to the heat sink 14 in addition to the first board supports 63. Also, the first board 43 may be fixed just to the heat sink 14, and not fixed to the first board supports 63. In this case, the external connector 42 does not need to have the first board supports 63.
   - Although the second board 44 is fixed to the second board supports 64 and the heat sink 14, this is not restrictive, and the second board 44 may be fixed just to the heat sink 14, and not fixed to the second board supports 64. In this case, the external connector 42 does not need to have the second board supports 64. Also, the second board 44 may be fixed just to the second board supports 64, and not fixed to the heat sink 14.
   - Although the first board 43 is fixed to the distal ends of the first board supports 63 by the first bolts 73, this is not restrictive, and the first board 43 may be fixed to the distal ends of the first board supports 63 by, for example, snap fits. Also, the first board 43 may be fixed to the distal ends of the first board supports 63 using an adhesive, for example, and the method of fixing the first board 43 to the first board supports 63 can be changed as appropriate. In the same way, the method of fixing the second board 44 to the second board supports 64 and the method of fixing the second board 44 to the heat sink 14 can be changed as appropriate.
   - Although the heat sink 14 has the raised portion 31 and the sunken portion 32, and has a stepped plate-like shape, this is not restrictive, and may have a generally flat plate-like shape, for example. In this case, only the first board 43 or the second board 44 will come into contact with the heat sink 14. Also, the heat sink 14 does not need to have the supporting protrusions 34, regardless of whether the heat sink 14 has the stepped plate-like shape or not.
   - The heat sink 14 does not need to have the positioning holes 36. Also, the heat sink 14 does not need to have the holding holes 33, regardless of the presence or absence of the positioning holes 36. In this case, the motor 2 may include a bearing holder that holds the bearing 27, separately from the heat sink 14.
   - The motor unit 1 does not need to include the inter-board connector pair 45. In this case, the first board 43 and the second board 44 may be electrically connected using a connecting member such as a bus bar, a connecting pin, or the like, for example.
   - The motor unit 1 does not need to include the cover 41.
- Although the motor 2 is a three-phase brushless motor, this is not restrictive, and may be another type of motor, such as a brushed motor or the like, for example. Also, the stator 12 may have a single coil group 22. That is to say, the motor 2 does not need to have the redundant configuration regarding the motor coils.
   - Although the control device 3 has a configuration in which the power supply system that supplies power to the coil group 22 and the control system are redundant, a configuration may be made in which only the power supply system is redundant.

## Claims

1. A motor unit, comprising:
a motor; and
a control device configured to control the motor, wherein
the control device includes
an external connector that is disposed spaced apart from the motor along an axis of the motor,
a first board that is disposed between the motor and the external connector, in an orientation intersecting the axis of the motor,
a second board that is disposed between the first board and the external connector, in array with the first board, and
a circuit component that is mounted on the first board and the second board, the external connector has
a base portion, and
a positioning pin protruding from the base portion toward the motor,
the first board has a first through hole,
the second board has a second through hole provided at a position corresponding to the first through hole, and
a common positioning pin is inserted into the first through hole and the second through hole.

2. The motor unit according to claim 1, wherein the control device further includes an inter-board connector pair including a first connector that is mounted on the first board and a second connector that is mounted on the second board and connected to the first connector.

3. The motor unit according to claim 1 or 2, wherein
the motor includes a heat sink that is made of a metal material,
the heat sink has
a raised portion, and
a sunken portion that is sunken further away from the external connector than the raised portion,
the second board is disposed on the raised portion so as to cover a part of the sunken portion,
the first board is disposed between the sunken portion and the second board, and
a heat dissipation material is interposed between the first board and the sunken portion, and between the second board and the raised portion.

4. The motor unit according to claim 3, wherein
the external connector further has a first board support that protrudes from the base portion toward the motor, and
the first board is fixed to a distal end of the first board support.

5. The motor unit according to claim 3 or 4, wherein
the external connector further has a second board support that protrudes from the base portion toward the motor, and
the second board is fixed to a distal end of the second board support.

6. The motor unit according to any one of claims 3 to 5, wherein
the heat sink has a positioning hole provided at a position corresponding to the first through hole and the second through hole, and
the common positioning pin is inserted into the first through hole, the second through hole, and the positioning hole.

7. The motor unit according to claim 6, wherein
the motor further includes
a rotating shaft, and
a sensor magnet fixed to an end portion of the rotating shaft,
the circuit component includes a magnetic sensor mounted on the first board or the second board so as to face the sensor magnet, and
the heat sink is configured to hold a bearing that rotatably supports the rotating shaft.

8. The motor unit according to claim 6 or 7, wherein
the positioning pin has a distal end portion that is inserted into the positioning hole,
an outer peripheral face of the distal end portion has a retaining recess, and
an inner peripheral face of the positioning hole has a retaining protrusion that retains the retaining recess.

9. The motor unit according to any one of claims 3 to 8, wherein
the circuit component includes a drive circuit component that makes up a drive circuit for supplying driving electric power to the motor, and
the drive circuit component is mounted on a region of the second board facing the raised portion.

10. The motor unit according to any one of claims 3 to 9, wherein
the circuit component includes a control circuit component that makes up a control circuit for controlling operations of the motor, and
the control circuit component is mounted on the first board.

11. The motor unit according to any one of claims 3 to 10, wherein
the second board is rigidly fixed to the heat sink,
the circuit component includes a large-sized and heavy component including a capacitor and a coil, and
the large-sized and heavy component is mounted on the second board.

12. The motor unit according to any one of claims 1 to 11, wherein the positioning pin has a contacting portion that is configured to come into contact with a facing face of the second board facing the external connector.
